(19) Europäisches Patentamt
European Patent Office
Office européen des brevets

(11) **EP 1 523 703 B1**

(12) **EUROPÄISCHE PATENTSCHRIFT**

(45) Veröffentlichungstag und Bekanntmachung des Hinweises auf die Patenterteilung:
**24.02.2010 Patentblatt 2010/08**

(21) Anmeldenummer: **03787666.1**

(22) Anmeldetag: **15.07.2003**

(51) Int Cl.:
*G05F 3/24* (2006.01)  *H03K 17/687* (2006.01)
*H03F 1/30* (2006.01)

(86) Internationale Anmeldenummer:
**PCT/DE2003/002377**

(87) Internationale Veröffentlichungsnummer:
**WO 2004/017153 (26.02.2004 Gazette 2004/09)**

(54) **BANDABSTANDS-REFERENZSCHALTUNG**

BAND-GAP REFERENCE CIRCUIT

CIRCUIT DE REFERENCE LARGEUR DE BANDE INTERDITE

(84) Benannte Vertragsstaaten:
**DE FR GB IT**

(30) Priorität: **23.07.2002 DE 10233526**

(43) Veröffentlichungstag der Anmeldung:
**20.04.2005 Patentblatt 2005/16**

(73) Patentinhaber: **Infineon Technologies AG**
**85579 Neubiberg (DE)**

(72) Erfinder:
• **BRASS, Eckhard**
**82008 Unterhaching (DE)**
• **GREWING, Christian**
**19146 Sollentuna (SE)**
• **OEHM, Jürgen**
**40885 Ratingen (DE)**

(74) Vertreter: **Viering, Jentschura & Partner**
**Postfach 22 14 43**
**80504 München (DE)**

(56) Entgegenhaltungen:
EP-A- 1 154 566    US-A- 5 083 043
US-A- 5 706 240

EP 1 523 703 B1

## EP 1 523 703 B1

**Beschreibung**

Die vorliegende Erfindung betrifft eine Bandabstands-Referenzschaltung gemäß dem Oberbegriff des Patentanspruchs 1.

Eine gattungsgemäße Bandabstands-Referenzschaltung ist beispielsweise in der Druckschrift H. Banba, H. Shiga et al. : "A CMOS Bandgap Reference Circuit with Sub-1-V Operation", IEEE Journal of Solid-State Circuits, Vol. 34, No. 5, May 1999 angegeben. Eine weitere Bandabstands-Referenzschaltung ist aus US 5 083 043 bekannt. Dort ist in Figur 1 der Schaltungsaufbau eines herkömmlichen Bandabstands-Referenzschaltkreises gezeigt. Dieser umfaßt einen Regelkreis mit einem CMOS-Operationsverstärker sowie mit Dioden und Widerständen. Ein Paar von Eingangsspannungen des Operationsverstärkers wird so geregelt, daß die Spannungen gleich sind. Die beiden Eingangsspannungen des Operationsverstärkers sind jeweils von der Durchflußspannung einer Diode in einem jeweiligen Stromzweig abhängig, der an den Ausgang des Operationsverstärkers angekoppelt ist.

Die Durchlaßspannung einer Diode hat normalerweise einen verhältnismäßig hohen Temperaturkoeffizienten von beispielsweise minus 2 mV pro Kelvin bei 0,6 Volt. Bei einer gattungsgemäßen Bandabstands-Referenz wird dieser Temperaturkoeffizient kompensiert, in dem eine Spannung mit einem Temperaturkoeffizienten von plus 2 mV pro Kelvin oder einem anderen, positiven Temperaturkoeffizienten entsprechend gewichtet addiert wird. Folglich ergibt sich die Ausgangs-Referenzspannung der Bandabstandsschaltung durch geeignete Wahl von Widerstandsverhältnissen in Verbindung mit möglichst großer DC-Verstärkung des Operationsverstärkers als Spannungswert, der praktisch unabhängig von der Temperatur ist. Dabei werden die Stromdichten der Dioden in den beiden Stromzweigen verschieden eingestellt.

Im Falle von Silizium als Halbleitermaterial ergibt sich die Referenzspannung einer derartigen Bandabstands-Schaltung normalerweise zu ca. 1,25 Volt.

In Figur 5 der oben zitierten Druckschrift Banba et al. ist der Operationsverstärker des Bandabstands-Referenzkreises als Schaltplan auf Bauteilebene dargestellt. Man erkennt, daß der Operationsverstärker als Differenzverstärker in MOS-Schaltungstechnik ausgeführt ist und an dem gemeinsamen Source-Knoten der Verstärkertransistoren über einen Stromspiegel das Ausgangssignal des Differenzverstärkers eingespeist wird. Dies hat zum einen den Nachteil, daß verhältnismäßig viele Bauteile für die Referenzstromerzeugung des Differenzverstärkers benötigt werden, zum anderen ist eine nachteilhafte Stromschleife gebildet, welche eine verhältnismäßig schlechte Versorgungsspannungsunterdrückung des Referenzstroms bietet. Die Versorgungsspannungsunterdrückung wird auch als PSRR, Power Supply Rejection Ratio, bezeichnet.

In Figur 5 des angeführten Dokuments H. Banba, H. Shiga et al. ist weiterhin eine Startschaltung zum Einschalten des Bandabstands-Referenzkreises angedeutet, mit einem NMOS-Transistor, der mit seiner gesteuerten Strecke den Ausgang des Differenzverstärkers mit Bezugspotential koppelt in Abhängigkeit von einem Einschalt-Steuersignal, welches mit einem zusätzlichen, nicht eingezeichneten Steuerschaltkreis erzeugt werden muß. Ein derartiger Steuerschaltkreis umfaßt normalerweise eine Vielzahl weiterer Bauelemente, insbesondere Transistoren und Kondensatoren. Ein derartiger Startschaltkreis ermöglicht ein zuverlässiges und verhältnismäßig schnelles Hochfahren des Bandabstands-Regelkreises, ist jedoch bei der Schaltung von Figur 5 mit verhältnismäßig großem Aufwand realisiert.

Aufgabe der vorliegenden Erfindung ist es, eine gattungsgemäße Bandabstands-Referenzschaltung so weiterzubilden, daß die Versorgungsspannungsunterdrückung verbessert ist. Insbesondere soll die Bandabstands-Referenzschaltung zur Anwendung in mobilen Geräten mit geringer Versorgungsspannung, welche verhältnismäßig großen Schwankungen unterworfen sein kann, geeignet sein.

Erfindungsgemäß wird die Aufgabe gelöst durch eine Bandabstands-Referenzschaltung mit den kennzeichnenden Merkmalen des vorliegenden Patentanspruches 1.

Der Referenzstrom für den Differenzverstärker wird gemäß dem vorliegenden Prinzip mit einem gegen Masse geschalteten Widerstand bereitgestellt und nicht mit einer Stromschleife aus dem Ausgangssignal des Differenzverstärkers abgeleitet.

Überaschenderweise ist die Verwendung eines Widerstands als Stromquelle bei der beschriebenen Bandabstands-Referenzschaltung möglich. Denn der Erfinder hat vorliegend erkannt, daß die Gleichtaktlagen an den Abgriffspunkten der Stromzweige es ermöglichen, daß der Strom mit einem Widerstand erzeugt werden kann.

Aufgrund dieser Gleichtaktlagen der Eingangssignale des Differenzverstärkers aus den Stromzweigen der Bandabstands-Referenzschaltung ist ein stabiler Betrieb des Differenzverstärkers ohne aufwendige Rückkopplung des Ausgangssignals des Differenzverstärkers möglich. Somit ist die Versorgungsspannungsunterdrückung der Referenzstromversorgung des Differenzverstärkers deutlich verbessert und zudem ist die beschriebene Referenzstromerzeugung für den Differenzverstärker mit deutlich verringertem Bauteilaufwand möglich. Anstelle von drei MOS-Transistoren ist lediglich ein Widerstand erforderlich.

Mit dem beschriebenen Prinzip der Referenzstromeinspeisung in einem Bandabstands-Referenzschaltkreis treten Stromstörungen aufgrund von Versorgungsspannungsschwankungen mit deutlich verringerter Gewichtung, nämlich lediglich im Logarithmus gewichtet auf.

Zudem ist mit Vorteil die Bildung einer Stromschleife vermieden, welche eine signifikant geringere-Stabilität gegen Versorgungsspannungsschwankungen bietet.

Mit der dem vorliegenden Prinzip zugrundeliegenden Referenzstromerzeugung mit einem Widerstand ist der zusätzliche Vorteil verbunden, daß der Bandabstands-Regelkreis schneller anläuft und schneller einschwingt und somit das Hochfahren des Referenzkreises, bis eine stabile Referenzspannung am Ausgang bereit gestellt wird, deutlich verkürzt ist.

In einer bevorzugten Weiterbildung der vorliegenden Referenzschaltung ist ein Startschaltkreis zum Einschalten oder Hochfahren derselben vorgesehen. Ein erster Transistor wird dabei von der am ersten Abgriffsknoten anliegenden Spannung gesteuert und wirkt in Abhängigkeit davon auf einen zweiten Transistor, der lastseitig den Ausgang des Differenzverstärkers mit dem Bezugspotentialanschluß koppelt.

Die vorliegende Startschaltung benötigt verhältnismäßig wenig Bauteile, hat einen einfachen Aufbau und ermöglicht dennoch ein wirksames und schnelles Hochfahren der Bandabstands-Referenzschaltung.

Der erste und der zweite Strompfad in der Bandabstands-Referenzschaltung sind mit ihren Stromeingängen bevorzugt miteinander verbunden und liegen demnach parallel zwischen einem bevorzugt vorgesehenen Steuertransistor und Bezugspotential. Der Steuertransistor ist mit seinem Steueranschluß mit dem Ausgang des Differenzverstärkers verbunden und mit seiner gesteuerten Strecke einerseits an einen Versorgungspotentialanschluß und andererseits mit den beiden Stromeingängen der Strompfade verschaltet. Das Vorsehen lediglich eines Steuertransistors, mit denen der Differenzverstärker die Ströme in den beiden Strompfaden steuert, bietet zum einen den Vorteil der geringen Anzahl von Bauteilen. Zum anderen aber kann mit Vorteil darauf verzichtet werden, eine gute Paarungstoleranz bei Vorsehen zweier Transistoren gewährleisten zu müssen.

Die Dioden, in Abhängigkeit von deren Durchflußspannung die Bandabstands-Referenzschaltung arbeitet, sind bevorzugt als Bipolardioden ausgebildet.

Bei Fertigung der Schaltung in CMOS-n-Wannen-Technik sind die Dioden bevorzugt als Bipolartransistoren ausgeführt, deren Basisanschluß jeweils mit ihrem Kollektoranschluß kurzgeschlossen ist. Somit ist als Diode die Basis-Emitter-Strecke des Transistors vorgesehen.

Abgesehen von den beiden als Referenzelemente arbeitenden Dioden ist die vorliegende Bandabstands-Referenzschaltung bevorzugt vollständig in MOS-Schaltungstechnik ausgeführt.

Weitere Einzelheiten und vorteilhafte Weiterbildungen der vorliegenden Erfindung sind Gegenstand der Unteransprüche.

Die Erfindung wird nachfolgend an einem Ausführungsbeispiel anhand der Zeichnungen näher erläutert.

Es zeigen:

Figur 1    ein erstes Ausführungsbeispiel der vorliegenden Bandabstands-Referenzschaltung anhand eines Schaltplanes,

Figur 2    den Frequenzgang der Versorgungsspannungsunterdrückung des Referenzstromes des Differenzverstärkers,

Figur 3    den Frequenzgang der Versorgungsspannungsunterdrükkung der ausgangsseitigen Bandgap-Schaltung und

Figur 4    ein zweites Ausführungsbeispiel der vorliegenden Bandabstands-Referenzschaltung anhand eines Schaltplänes.

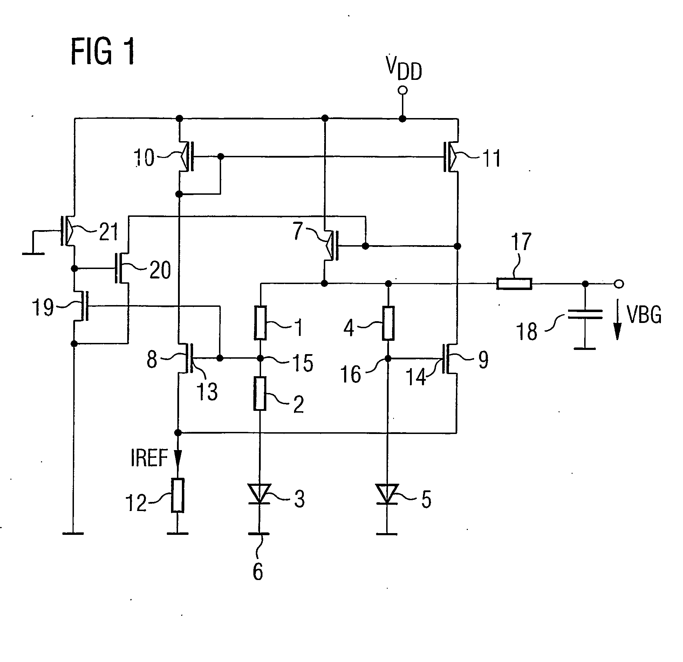

Figur 1 zeigt ein Ausführungsbeispiel einer in CMOS-Schaltungstechnik aufgebauten Bandabstands-Referenzschaltung, welche als Spannungsreferenz die Durchlaßspannung von Dioden einsetzt. Ein erster Strompfad umfaßt eine Serienschaltung aus einem ersten Widerstand 1, einem zweiten Widerstand 2 und einer ersten Diode 3. Parallel zu diesem ersten Strompfad 1, 2, 3 ist ein zweiter Strompfad 4, 5 geschaltet, der einen dritten Widerstand 4 sowie eine zweite Diode 5 umfaßt, welche ebenfalls in einer Serienschaltung miteinander verbunden sind. Die beiden Stromeingänge der Strompfade 1, 2, 3; 4, 5 sind jeweils an den freien Anschlüssen des ersten beziehungsweise des dritten Widerstands 1, 4 gebildet. Diese Stromeingänge sind miteinander verbunden. Weiterhin sind die Kathodenanschlüsse der Dioden 3, 5 jeweils mit einem Bezugspotentialanschluß 6 verbunden. Zwischen einen Versorgungsspannungsanschluß $V_{DD}$ und die Stromeingänge der Strompfade 1, 2, 3; 4, 5 ist ein Steuertransistor 7 mit seiner Laststrecke geschaltet, der als PMOS-Transistor ausgeführt ist. Der Steuereingang des Steuertransistors 7 ist mit dem Ausgang eines Differenzverstärkers, der als Operationsverstärker arbeitet, verbunden.

Der Differenzverstärker 8, 9, 10, 11, 12 umfaßt einen ersten Verstärkertransistor 8, einen zweiten Verstärkertransistor 9, einen Stromspiegel 10, 11 sowie einen Widerstand 12, welcher als Referenzstromquelle arbeitet. Die beiden Verstärkertransistoren 8, 9 sind als MOS-Feldeffekttransistoren mit n-Kanal ausgeführt und haben jeweils einen Steuereingang, wobei die Steuereingänge der Verstärkertransistoren 8, 9 den ersten und den zweiten Eingang 13, 14 des Differenzverstärkers bilden. Die gesteuerten Strecken der beiden Verstärkertransistoren 8, 9 sind mit je einem ersten Anschluß über den Stromspiegel 10, 11 miteinander verbunden und an ihren zweiten Anschlüssen der gesteuerten Strecken unmittelbar miteinander verbunden und über den Referenzstromquellenwiderstand 12 gegen Bezugspotential 6 geschaltet. Die Stromspiegeltransistoren 10, 11 sind mit ihren Gateanschlüssen unmittelbar miteinander verbunden und mit je einem Lastanschluß unmittelbar an Versorgungspotential V$_{DD}$ gelegt. Der Stromspiegeltransistor 10, der als Diode verschaltet ist, ist wie Stromspiegeltransistor 11 als p-Kanal MOS-Feldeffekttransistor ausgeführt.

Erster und zweiter Eingang 13, 14 des Differenzverstärkers sind mit je einem Abgriffspunkt 15, 16 am ersten und am zweiten Strompfad 1, 2, 3; 4, 5 verbunden. Der erste Abgriffspunkt 15 ist an dem gemeinsamen Verbindungsknoten der Widerstände 1, 2 gebildet. Der zweite Abgriffsknoten 16 ist zwischen dem dritten Widerstand 4 und der zweiten Diode 5 an deren Anodenanschluß vorgesehen.

Der Ausgang der Bandabstands-Referenzschaltung von Figur 1 ist am gemeinsamen Verbindungsknoten von dem Stromeingang des ersten Strompfades 1, 2, 3, dem Stromeingang des zweiten Strompfades 4, 5 und dem damit verbundenen Anschluß der gesteuerten Strecke des Steuertransistors 7 gebildet. An diesen Verbindungsknoten ist ein RC-Glied umfassend einen Serienwiderstand 17 und einen Kondensator 18 gegen Bezugspotential oder Masse, der dem Widerstand 17 nachgeschaltet ist, angeschlossen. An dem Ausgangsanschluß des RC-Glieds 17, 18 wird das tiefpaßgefilterte Bandabstands-Referenzsignal bereitgestellt.

Zum Hochfahren der Bandabstands-Referenzschaltung ist eine Startschaltung 19, 20, 21 vorgesehen, welche einen ersten Transistor 19, einen zweiten Transistor 20, sowie einen als elektrische Last verschalteten Transistor 21 umfaßt. Während erster und zweiter Transistor 19, 20 als NMOS-Transistoren ausgebildet sind, ist die elektrische Last ein PMOS-Transistor 21. Transistor 21 und Transistor 19 bilden bezüglich ihrer gesteuerten Strecken eine Serienschaltung und sind zwischen Versorgungspotentialanschluß V$_{DD}$ und Bezugspotentialanschluß 6 geschaltet. Der Lasttransistor 21 ist mit seinem Steueranschluß ebenfalls an Bezugspotential geschaltet und ist somit stets leitend. Der Steuereingang des Transistors 19 ist mit dem ersten Abgriffsknoten 15 des ersten Strompfades 1, 2, 3 verbunden. Der zweite Transistor 20 ist mit seinem Steuereingang an den Verbindungsknoten der Transistoren 19, 21 angeschaltet und verbindet lastseitig den Steuereingang des Steuertransistors 7 mit Bezugspotentialanschluß 6.

Der Operationsverstärker, der vorliegend als Differenzverstärker ausgebildet ist, regelt die sich an den beiden Abgriffspunkten 15, 16 einstellenden Potentiale nach einer Einschwingphase stets so aus, daß diese gleich sind. Daraus ergibt sich, daß die Durchlaßspannung der zweiten Diode 5 gleich der Summe der Spannungen über Widerstand 2 und Diode 3 ist. Die Diode 3 ist dabei bevorzugt als Parallelschaltung mehrerer Teildioden ausgebildet. Die elektrischen Verhältnisse der Schaltung von Figur 1 werden durch nachstehende Formeln beschrieben. Darin bezeichnen U$_{PTAT}$ die Temperaturspannung über dem Widerstand 2, k die Boltzmann-Konstante, T die absolute Temperatur in Kelvin, q die Elementarladung, I$_{S5}$ die Stromdichte der Diode 5, I$_{S3}$ die Stromdichte der Diode 3, U$_1$ bis U$_5$ die Spannungen über den Widerständen 1 bis 5, R1, R2 die Werte der Widerstände 1, 2 und U$_{BG}$ die Bandgap-Spannung.

$$U_{PTAT} = \frac{k \cdot T}{q} \cdot \ln\left(\frac{I_{S5}}{I_{S3}}\right)$$

$$U_1 = R_1 \cdot \frac{U_{PTAT}}{R_2} = \frac{R_1}{R_2} \cdot \frac{k \cdot T}{q} \cdot \ln\left(\frac{I_{S5}}{I_{S3}}\right) \cdot$$

$$U_{PTAT} + U_3 = U_5$$

$$U_1 = U_4$$

$$U_{BG} = U_5 + U_1 = U_5 + \frac{R_1}{R_2} \cdot \frac{k \cdot T}{q} \cdot \ln\left(\frac{I_{S5}}{I_{S3}}\right) \overset{!}{\approx} 1{,}25V$$

Aufgrund der Erkenntnis, daß an den Abgriffsknoten 15, 16 ein Signalpaar mit geeigneter, ausreichender Gleichtaktlage vorliegt, ist gemäß vorliegendem Prinzip am Referenzstromeingang des Differenzverstärkers als Stromquelle der Widerstand 12 gegen Masse angeschaltet. Dies wiederum ermöglicht die Bereitstellung eines Referenzstromes mit besonders guter Versorgungsspannungsunterdrückung (englisch Power Supply Rejection Ratio, PSRR), da Störungen auf der Versorgungsspannung gemäß vorliegendem Prinzip nur logarithmisch gewichtet eingehen. Für den Referenzstrom $I_{ref}$ gilt

$$I_{ref} = \frac{U_5 - U_{GS8}}{R_{12}}$$

Dabei repräsentiert $U_{GS8}$ die Gate-Source-Spannung des Transistors 8 und $R_{12}$ den Wert des Widerstands 12.

Zusätzlich bietet die Einfachheit der Referenzstromerzeugung den Vorteil der geringen erforderlichen Bauteile und damit eine signifikante Chipflächenersparnis. Die verbesserte Versorgungsspannungsunterdrückung des Referenzstromes führt zusätzlich zu dem Vorteil einer verbesserten Signalqualität am Ausgang der Bandabstands-Referenzschaltung.

Die Startschaltung 19, 20, 21 umfaßt lediglich drei MOS-Transistoren und ist wie die übrige Bandabstands-Referenzschaltung für besonders geringe Versorgungsspannungen $V_{DD}$ ausgelegt. In Abhängigkeit von dem am ersten Abgriffspunkt 15 anliegenden Spannungspegel wird Transistor 19 angesteuert. Dabei ist zu beachten, daß der Transistor 21 stets etwas leitend ist. Der zweite Transistor 20 steuert den Transistor 7 durch Abziehen von Strom. Sobald die Referenzspannungserzeugung angelaufen ist, und ein bestimmter Stromfluß in der Schaltung erzielt ist, wird der Transistor 19 leitend und der Transistor 20 wird demnach an seinem Gate abgeschaltet. Somit funktioniert die Startschaltung mit einfachen Mitteln besonders wirksam.

Aufgrund der verbesserten Spannungsversorgungsunterdrückung und aufgrund der geringen, möglichen Versorgungsspannung ist die vorliegende Schaltung besonders zur Anwendung in mobilen Geräten geeignet, welche aus Akkumulatoren gespeist werden. Besonders bei derartigen Geräten sind verhältnismäßig große Schwankungen in der Versorgungsspannung gegeben.

Vorteilhafterweise ist die vorliegende Bandabstands-Referenzschaltung vollständig in CMOS-Schaltungstechnik aufgebaut und somit insbesondere zur Verwendung in Double Data Rate-Synchronous Dynamic Random Access Memories (DDR-SDRAMs) und anderen Halbleiterspeichern, sowie auch im Mobilfunk einsetzbar, wie beispielsweise in Bluetooth- oder DECT(Digital European Cordless Telephone)-Geräten.

Die vorgestellte Bandabstands-Referenzschaltung funktioniert noch bei Versorgungsspannungen von 1,3 Volt zuverlässig.

Anstelle der gezeigten Dioden 3, 5, deren Durchflußspannung als Referenz für die Bandabstandsreferenzschaltung dienen, können auch Transistoren verwendet werden, bei denen dann die Basis-Emitter-Strecken durch Kurzschließen von Basis und Kollektor als Referenzgrundlage dienen.

Anstelle der in Figur 1 gezeigten MOS-Transistoren können im Rahmen der Erfindung selbstverständlich auch andere Transistortypen mit jeweils fachüblicher Beschaltung eingesetzt werden.

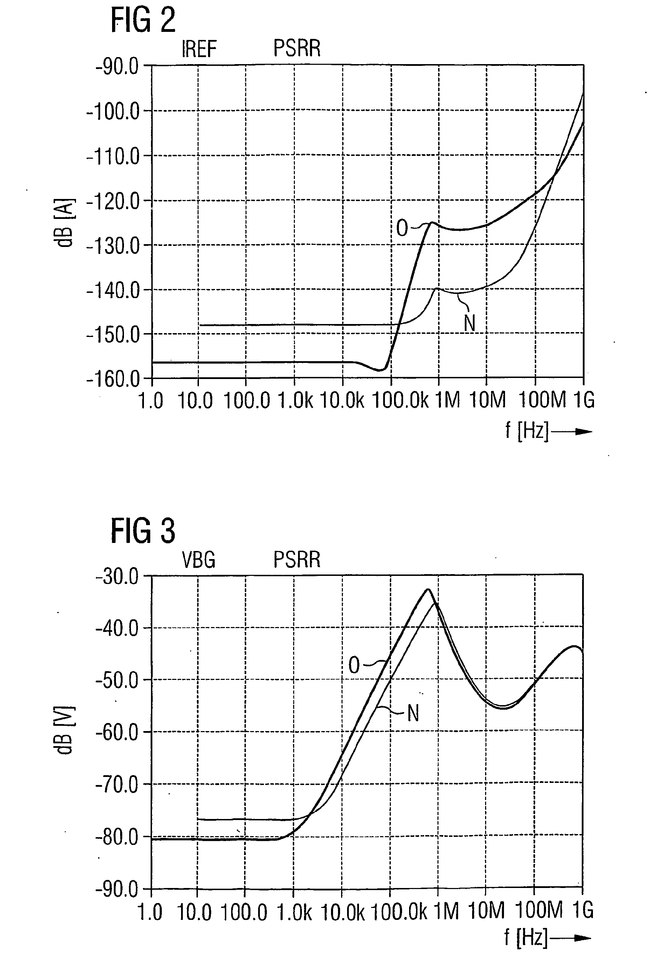

Figur 2 zeigt anhand eines Schaubilds in logarithmischer Darstellung den Frequenzgang der Versorgungsspannungsunterdrückung PSRR des Referenzstromes IREF des Differenzverstärkers. Dabei ist die Versorgungsspannungsunterdrückung des Referenzstromes des Differenzverstärkers aus Figur 1 in dB(A) über der Frequenz in Hertz aufgetragen. Kurve N beschreibt den Frequenzgang der Schaltung von Figur 1, während die Kurve O den Frequenzgang der eingangs erwähnten, bereits bekannten Bandabstands-Referenzschaltung charakterisiert. Im technisch besonders wichtigen, mittleren Frequenzbereich zwischen 100 kHz und 100 MHz ergibt sich eine Verbesserung der Versorgungsspannungsunterdrückung mit der vorgestellten Schaltung von bis zu 20 dB.

Figur 3 zeigt anhand eines Schaubilds in logarithmischer Darstellung den Frequenzgang der Versorgungsspannungsunterdrückung der Bandgap-Schaltung von Figur 1 insgesamt. Dabei ist die Versorgungsspannungsunterdrückung PSRR der erzeugten Bandgap-Spannung VBG am Ausgang der Schaltung über der Frequenz in Hertz aufgetragen. Auch hier beschreibt die Kurve N das Verhalten der Schaltung von Figur 1, während sich die Kurve O auf die eingangs erwähnte, bekannte Bandgap-Schaltung bezieht. Es ergibt sich eine verbesserte Versorgungsspannungsunterdrückung von ca. 3 dB über einen weiten Frequenzbereich.

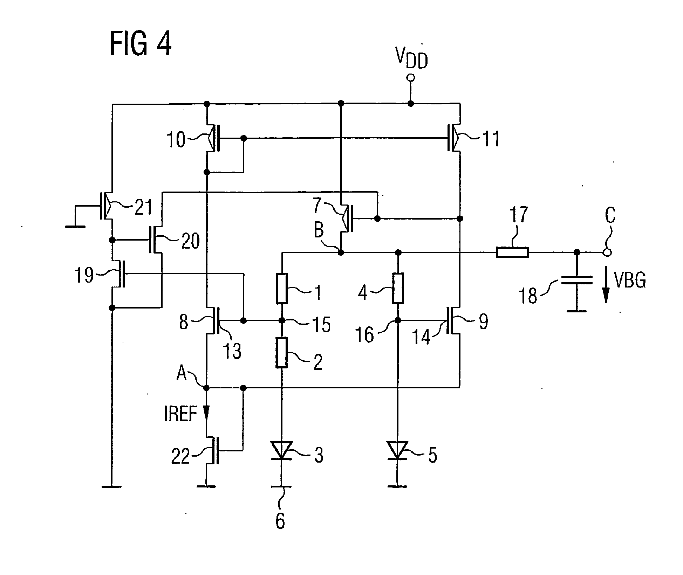

Figur 4 zeigt ein weiteres Ausführungsbeispiel einer in CMOS-Schaltungstechnik aufgebauten Bandabstands-Referenzschaltung, welche als Spannungsreferenz die Durchlaßspannung von Dioden einsetzt. Diese entspricht in Aufbau und Funktionsweise weitgehend derjenigen von Figur 1 und soll in soweit an dieser Stelle nicht noch einmal wiederholt werden. Anstelle des Widerstands 12 von Figur 1 ist bei Figur 4 ein Transistor 22 vorgesehen, dessen Steueranschluß zum Einstellen der Leitfähigkeit an einem aus einer Menge von geeigneten Schaltungsknoten der Referenzschaltung angeschlossen ist. Als solche Schaltungsknoten eignen sich beispielsweise die Abgriffsknoten 15, 16, ebenso jedoch der die Transistoren 8 und 9 verbindende Knoten A oder der Ausgangsknoten B, C der Bandabstands-Referenzschaltung vor oder nach dem Tiefpaß-Filter 17, 18.

Bezugszeichenliste

| | |
|---|---|
| 1 | Widerstand |
| 2 | Widerstand |
| 3 | Diode |
| 4 | Widerstand |
| 5 | Diode |
| 6 | Masse |
| 7 | Steuertransistor |
| 8 | Verstärkertransistor |
| 9 | Verstärkertransistor |
| 10 | Stromspiegeltransistor |
| 11 | Stromspiegeltransistor |
| 12 | Widerstand |
| 13 | Eingang |
| 14 | Eingang |
| 15 | Abgriffsknoten |
| 16 | Abgriffsknoten |
| 17 | Widerstand |
| 18 | Kondensator |
| 19 | Transistor |
| 20 | Transistor |
| 21 | Lasttransistor |
| 22 | Transistor |

**Patentansprüche**

1. Bandabstands-Referenzschaltung, mit

   - einem ersten Strompfad (1, 2, 3) umfassend einen Stromeingang, eine erste Diode (3) und einen ersten Abgriffsknoten (15) zum Abgreifen einer von der Durchlaßspannung der ersten Diode (3) abhängigen Spannung,
   - einem zweiten Strompfad (4, 5) umfassend einen Stromeingang, einen Widerstand (4), eine zweite Diode (5) und einen zweiten Abgriffsknoten (16) zum Abgreifen einer von der Durchlaßspannung der zweiten Diode (5) abhängigen Spannung und mit
   - einem Differenzverstärker (8, 9, 10, 11) umfassend einen ersten Eingang (13), der mit dem ersten Abgriffsknoten (15) verbunden ist, einen zweiten Eingang (14), der mit dem zweiten Abgriffsknoten (16) verbunden ist, einen Biasstromeingang und einen Ausgang, der mit den Stromeingängen von erstem und zweitem Strompfade (1, 2, 3; 4, 5) gekoppelt ist und an dem ein von der Spannungsdifferenz an den Eingängen abhängiges Signal bereitgestellt wird,

   **dadurch gekennzeichnet, daß**
   an den Biasstromeingang des Differenzverstärkers (8, 9, 10, 11) ein Widerstand (12) gegen einen Bezugspotentialanschluß (6) angeschaltet ist zur Bereitstellung eines Referenzstromes (IREF) für den Differenzverstärker.

2. Bandabstands-Referenzschaltung nach Anspruch 1,
   **dadurch gekennzeichnet, daß**

ein Startschaltkreis (19, 20, 21) zum Einschalten der Bandabstands-Referenzschaltung vorgesehen ist, umfassend einen ersten Transistor (19), mit einem Steuereingang, der mit dem ersten Abgriffsknoten (15) verbunden ist, und mit einer gesteuerten Strecke, die eine elektrische Last (21) mit dem Bezugspotentialanschluß (6) verbindet, und einen zweiten Transistor (20), mit einem Steuereingang, der mit der gesteuerten Strecke des ersten Transistors (19) verbunden ist und lastseitig den Ausgang des Differenzverstärkers mit dem Bezugspotentialanschluß (6) koppelt.

3. Bandabstands-Referenzschaltung nach Anspruch 2,
   **dadurch gekennzeichnet, daß**
   die elektrische Last (21) im Startschaltkreis als Transistor ausgebildet ist, der einen Versorgungspotentialanschluß ($V_{DD}$) mit einem Anschluß der gesteuerten Strecke des ersten Transistors (19) koppelt.

4. Bandabstands-Referenzschaltung nach einem der Ansprüche 1 bis 3,
   **dadurch gekennzeichnet, daß**
   der erste Strompfad (1, 2, 3) eine Serienschaltung aus einem ersten Widerstand (1), einem zweiten Widerstand (2) und der ersten Diode (3) umfaßt, wobei der erste Abgriffspunkt (15) zwischen dem ersten und dem zweiten Widerstand (1, 2) angeordnet ist, und daß
   der zweite Strompfad (4, 5) eine Serienschaltung aus einem dritten Widerstand (4) und der zweiten Diode (4) umfaßt, zwischen denen der zweite Abgriffspunkt (16) angeordnet ist.

5. Bandabstands-Referenzschaltung nach einem der Ansprüche 1 bis 4,
   **dadurch gekennzeichnet, daß**
   der Differenzverstärker (8, 9, 10, 11) einen ersten und einen zweiten Verstärkertransistor (8, 9) umfaßt, mit Steuereingängen, die die beiden Eingänge (13, 14) des Differenzverstärkers bilden, und mit je einem Anschluß der gesteuerten Strekke mit dem Biasstromeingang des Differenzverstärkers verbunden sind, und daß die freien Anschlüsse der gesteuerten Strecken der Verstärkertransistoren (8, 9) mittels eines Stromspiegels (10, 11) miteinander verschaltet sind.

6. Bandabstands-Referenzschaltung nach einem der Ansprüche 1 bis 5,
   **dadurch gekennzeichnet, daß**
   zur Kopplung des Ausgangs des Differenzverstärkers (8, 9, 10, 11) mit den Stromeingängen des ersten und des zweiten Strompfades (1, 2, 3; 4, 5) ein Steuertransistor (7) vorgesehen ist, mit einem Steuereingang, der mit dem Ausgang des Differenzverstärkers (8, 9, 10, 11) verbunden ist, und mit einer gesteuerten Strecke, die einen Versorgungspotentialanschluß ($V_{DD}$) mit den beiden Stromeingängen von erstem und zweitem Strompfad (1, 2, 3; 4, 5) und mit dem Ausgang der Bandabstands-Referenzschaltung koppelt.

7. Bandabstands-Referenzschaltung nach Anspruch 6,
   **dadurch gekennzeichnet, daß**
   an den Ausgang der Bandabstands-Referenzschaltung ein Tiefpass-Filter (17, 18) angeschlossen ist.

8. Bandabstands-Referenzschaltung nach einem der Ansprüche 1 bis 6,
   **dadurch gekennzeichnet, daß**
   der zur Bereitstellung des Referenzstromes (IREF) für den Differenzverstärker (8, 9, 10, 11) zwischen den Biasstromeingang des Differenzverstärkers (8, 9, 10, 11) und den Bezugspotentialanschluß (6) angeschlossene Widerstand (12) als Transistor (22) ausgeführt ist.

9. Bandabstands-Referenzschaltung nach Anspruch 8,
   **dadurch gekennzeichnet, daß**
   der zur Bereitstellung des Referenzstromes (IREF) für den Differenzverstärker (8, 9, 10, 11) ausgelegte Transistor (22) einen Steuereingang umfaßt, der zur Einstellung der Leitfähigkeit an den Biasstromeingang (A) des Differenzverstärkers (8, 9, 10, 11), an den Ausgang (B, C) der Referenzschaltung oder an einen der beiden Abgriffsknoten (15, 16) angeschlossen ist.

**Claims**

1. Bandgap reference circuit, comprising

- a first current path (1, 2, 3) comprising a current input, a first diode (3) and a first tapping node (15) for tapping off a voltage dependent on the forward voltage of the first diode (3),
- a second current path (4, 5) comprising a current input, a resistor (4), a second diode (5) and a second tapping node (16) for tapping off a voltage dependent on the forward voltage of the second diode (5), and comprising
- a differential amplifier (8, 9, 10, 11) comprising a first input (13), which is connected to the first tapping node (15), a second input (14), which is connected to the second tapping node (16), a bias current input and an output, which is coupled to the current inputs of the first and the second current paths (1, 2, 3; 4, 5) and at which a signal dependent on the voltage difference at the inputs is provided,

**characterized in that**
a resistance (12) is connected between the bias current input of the differential amplifier (8, 9, 10, 11) and a reference potential terminal (6) for providing a reference current (IREF) for the differential amplifier.

2. Bandgap reference circuit according to claim 1,
**characterized in that**
a start circuit (19, 20, 21) is provided to activate the bandgap reference circuit, comprising a first transistor (19) having a control input, which is connected to the first tapping node (15) and having a controlled path, which connects an electrical load (21) to the reference potential terminal (6), and a second transistor (20) having a control input, which is connected to the controlled path of the first transistor (19) and couples the output of the differential amplifier to the reference potential terminal (6) on the load side.

3. Bandgap reference circuit according to claim 2,
**characterized in that**
the electrical load (21) in the start circuit is formed as a transistor that couples a supply potential terminal ($V_{DD}$) to a terminal of the controlled path of the first transistor (19).

4. Bandgap reference circuit according to one of the claims 1 to 3,
**characterized in that**
the first current path (1, 2, 3) comprises a serial connection of a first resistor (1), a second resistor (2) and the first diode (3), wherein the first tapping node (15) is arranged between the first and the second resistor (1, 2), and **in that** the first current path (4, 5) comprises a serial connection of a third resistor (4) and the second diode (4), between which the second tapping point (16) is arranged.

5. Bandgap reference circuit according to one of claims 1 to 4,
**characterized in that**
the differential amplifier (8, 9, 10, 11) comprises a first and a second amplifier transistor (8, 9) having control inputs, which form the two inputs (13, 14) of the differential amplifier and which are connected by a respective terminal of the controlled path to the bias current input of the differential amplifier, and that the free terminals of the controlled paths of the amplifier transistors (8, 9) are coupled to one another through a current mirror (10, 11).

6. Bandgap reference circuit according to one of the claims 1 to 5,
**characterized in that**
a control transistor (7) is provided for coupling the output of the differential amplifier (8, 9, 10, 11) to the current inputs of the first and the second current paths (1, 2, 3; 4, 5), having a control input connected to the output of the differential amplifier (8, 9, 10, 11), and having a controlled path, which couples a supply potential terminal ($V_{DD}$) to the two current inputs of the first and the second current path (1, 2, 3; 4, 5) and to the output of the bandgap reference circuit.

7. Bandgap reference circuit according to claim 6,
**characterized in that**
a low-pass filter (17, 18) is connected to the output of the bandgap reference circuit.

8. Bandgap reference circuit according to one of the claims 1 to 6,
**characterized in that**
the resistor (12) connected between the bias current input of the differential amplifier (8, 9, 10, 11) and the reference potential terminal (6) for providing the reference current (IREF) for the differential amplifier (8, 9, 10, 11) is designed as a transistor (22).

**9.** Bandgap reference circuit according to claim 8,
**characterized in that**
the transistor (22) designed for providing the reference current (IREF) for the differential amplifier (8, 9, 10, 11) comprises a control input, which is connected to the bias current input (A) of the differential amplifier (8, 9, 10, 11), to the output (B, C) of the reference circuit or to one of the two tapping nodes (15, 16) for adjusting the conductance.

**Revendications**

**1.** Circuit de référence largeur de bande interdite, comprenant

- un premier trajet (1, 2, 3) de courant comprenant une entrée de courant, une première diode (3) et un premier noeud (15) de prélèvement pour le prélèvement d'une tension, qui dépend de la tension dans le sens direct de la première diode (3),
- un deuxième trajet (4, 5) de courant comprenant une entrée de courant, une deuxième diode (5) et un deuxième noeud (16) de prélèvement pour le prélèvement d'une tension, qui dépend de la tension dans le sens direct de la deuxième diode (5) et comprenant
- un amplificateur (8, 9, 10, 11) différentiel comprenant une première entrée (13), qui est reliée au premier noeud (15) de prélèvement, une deuxième entrée (14), qui est reliée au deuxième noeud (16) de prélèvement, une entrée de courant de polarisation et une sortie, qui est couplée aux entrées de courant du premier et du deuxième trajets (1, 2, 3, 4, 5) de courant et sur laquelle est disponible un signal, qui dépend de la différence de tension aux entrées,

**caractérisé en ce que**
à l'entrée du courant de polarisation de l'amplificateur (8, 9, 10, 11) différentiel, est branchée une résistance (12) par rapport à une borne (6) de potentiel de référence, pour disposer d'un courant (IREF) de référence pour l'amplificateur différentiel.

**2.** Circuit de référence largeur de bande interdite suivant la revendication 1,
**caractérisé en ce que**
il est prévu, pour la mise en circuit du circuit de référence largeur de bande, un circuit (19, 20, 21) de démarrage comprenant un premier transistor (19) ayant une entrée de commande, qui est reliée au premier noeud (15) de prélèvement et une section commandée, qui relie une charge (21) électrique à la bande (6) de potentiel de référence, et un deuxième transistor (20) ayant une entrée de commande, qui est reliée à la section commandée du premier transistor (19) et qui couple, du côté de la charge, la sortie de l'amplificateur différentiel à la borne (6) de potentiel de référence.

**3.** Circuit de référence largeur de bande interdite suivant la revendication 2,
**caractérisé en ce que**
la charge (21) électrique dans le circuit de démarrage est constituée sous la forme d'un transistor, qui couple une borne ($V_{DD}$) de potentiel d'alimentation à une borne de la section commandée du premier transistor (19).

**4.** Circuit de référence largeur de bande interdite suivant l'une des revendications 1 à 3,
**caractérisé en ce que**
le premier trajet (1, 2, 3) de courant comprend un circuit série composé d'une première résistance (1), d'une deuxième résistance (2) et de la première diode (3), le premier point (15) de prélèvement étant disposé entre la première et la deuxième résistances (1, 2), et **en ce que**
le deuxième trajet (4, 5) de courant comprend un circuit série composé d'une troisième résistance (4) et de la deuxième diode (4) entre lesquelles est disposé le deuxième point (16) de prélèvement.

**5.** Circuit de référence largeur de bande interdite suivant l'une des revendications 1 à 4,
**caractérisé en ce que**
l'amplificateur (8, 9, 10, 11) différentiel comprend un premier et un deuxième transistors (8, 9) d'amplificateur ayant des entrées de commande, qui forment les deux entrées (13, 14) de l'amplificateur différentiel, et qui sont reliées par respectivement une borne des sections commandées à l'entrée de courant de polarisation de l'amplificateur différentiel et **en ce que** les bornes libres des sections commandées des transistors (8, 9) d'amplificateur sont câblées entre elles au moyen d'un miroir de courant (10, 11).

**6.** Circuit de référence largeur de bande interdite suivant l'une des revendications 1 à 5, **caractérisé en ce que** pour le couplage de la sortie de l'amplificateur (8, 9, 10, 11) différentiel aux entrées de courant du premier et du deuxième trajets (1, 2, 3, 4, 5) de courant, il est prévu un transistor (7) de commande ayant une entrée de commande, qui est reliée à la sortie de l'amplificateur (8, 9, 10, 11) différentiel, et ayant une section commandée, qui couple une borne ($V_{DD}$) de potentiel d'alimentation aux deux entrées de courant du premier et du deuxième trajets (1, 2, 3, 4, 5) de courant et à la sortie du circuit de référence largeur de bande interdite.

**7.** Circuit de référence largeur de bande interdite suivant la revendication 6, **caractérisé en ce que** un filtre (17, 18) passe-bas est raccordé à la sortie du circuit de référence largeur de bande interdite.

**8.** Circuit de référence largeur de bande interdite suivant l'une des revendications 1 à 6, **caractérisé en ce que** pour disposer du courant (IREF) de référence pour l'amplificateur (8, 9, 10, 11) différentiel, une résistance (12) raccordée entre l'entrée du courant de polarisation de l'amplificateur (8, 9, 10, 11) différentiel et la borne (6) de potentiel de référence est réalisée en transistor (22).

**9.** Circuit de référence largeur de bande interdite suivant la revendication 8, **caractérisé en ce que** pour disposer du courant (IREF) de référence, un transistor (22) conçu pour l'amplificateur (8, 9, 10, 11) différentiel comprend une entrée de commande, qui, pour régler la conductivité sur l'entrée (A) du courant de polarisation de l'amplificateur (8, 9, 10, 11) différentiel, est raccordée à la sortie (B, C) du circuit de référence ou à l'un des deux noeud (15, 16) de prélèvement.

FIG 1

## FIG 2

## FIG 3

## FIG 4

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 5083043 A

**In der Beschreibung aufgeführte Nicht-Patentliteratur**

- **H. Banba ; H. Shiga e.** A CMOS Bandgap Reference Circuit with Sub-1-V Operation. *IEEE Journal of Solid-State Circuits,* Mai 1999, vol. 34 (5